# EUROPEAN PATENT SPECIFICATION

(11) **EP 3 100 359 B1**
(45) Date of publication and mention of the grant of the patent: **15.11.2017**
(21) Application number: 15742811.1
(22) Date of filing: 26.01.2015
(51) Int. Cl.: H03L 7/26, H01S 1/06, H05K 1/18, H05K 3/34, G04F 5/14

(54) **ATOMIC OSCILLATOR AND PRODUCTION METHOD THEREOF**
ATOMOSZILLATOR UND HERSTELLUNGSVERFAHREN DAFÜR
OSCILLATEUR ATOMIQUE ET SON PROCÉDÉ DE FABRICATION

(30) Priority: 30.01.2014 JP 2014015420; 21.11.2014 JP 2014236386
(43) Date of publication of application: 07.12.2016
(73) Proprietor: Ricoh Company, Ltd., Tokyo 143-8555 (JP)
(72) Inventor: ADACHI, Kazuhiko, Tokyo 143-8555 (JP); HARASAKA, Kazuhiro, Tokyo 143-8555 (JP); ITOH, Akihiro, Tokyo 143-8555 (JP)
(74) Representative: J A Kemp
(86) International application number: PCT/JP2015/052787
(87) International publication number: WO 2015/115632

(56) References cited:
- JP-A- 2004 221 793
- JP-A- 2004 221 793
- JP-A- 2007 178 273
- JP-A- 2009 188 598
- JP-A- 2014 007 300
- JP-A- 2014 007 300
- US-A1- 2006 022 761
- US-A1- 2011 219 729
- US-A1- 2011 219 729

## Description

The present invention relates to an atomic oscillator and a production method thereof.

There are atomic clocks (atomic oscillators) for measuring time very accurately and discussions on techniques for downsizing such atomic clocks have been held. The atomic clock includes an oscillator that operates based on an amount of transition energy of electrons constituting atoms of alkali metal or the like. In particular, because transition energy of electrons constituting atoms of alkali metal can provide a very precise value if there is no disturbance, it is possible to obtain frequency stability that is a few places higher compared with a crystal oscillator.

Among several types of such atomic clocks, a Coherent Population Trapping (CPT) atomic clock has frequency stability that is about three places higher compared with a crystal oscillator and is expected to provide a very small size and ultra-low power consumption (Non-patent Documents 1 and 2, for example)

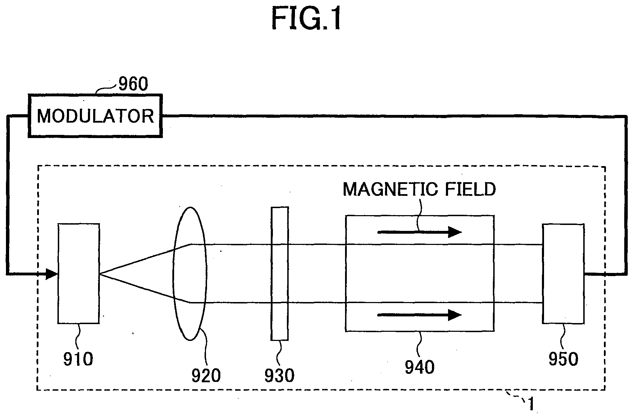

The CPT atomic clock includes a light source 910 such as a laser device, an alkali metal cell 940 in which alkali metal is enclosed, and a light detector 950 for receiving a laser beam that passes through the alkali metal cell 940 as shown in FIG. 1. When the laser beam is modulated, sideband wavelengths that appear on both sides of a carrier wave having a specific wavelength simultaneously cause two transitions of electrons in the alkali metal to excite the electrons. Transition energy in the transitions is constant and when the sideband wavelengths of the laser beam match a wavelength that corresponds to the transition energy, a transparency phenomenon occurs where absorption of light in the alkali metal declines. In the atomic clock, the wavelength of the carrier wave is adjusted to reduce the absorption of light in the alkali metal in this manner. In addition, a signal detected by the light detector 950 is fed back to a modulator 960 and the modulator 960 adjusts a modulation frequency of a laser beam from the light source 910 such as a laser device. The laser beam is emitted by the light source 910, irradiated onto the alkali metal cell 940 via a collimator lens 920 and a quarter-wave plate 930, and projected onto the light detector 950. Elements from the light source 910 to the light detector 950 are collectively referred to as a quantum unit (indicated by "1" in drawings) and downsizing of the quantum unit has been desired in order to improve performance.

A method for producing an alkali metal cell in such a very small-sized atomic clock using a Micro Electro Mechanical Systems (MEMS) technique is disclosed (Patent Documents 1-4, for example). Methods disclosed in these Patent Documents first form an opening in a Si substrate using a photolithographic technique and an etching technique and then bond glass to the Si substrate by anodic bonding. The anodic bonding is performed by applying a voltage ranging from about 250 to 1000 V to an interface between the glass and the Si substrate at a temperature ranging from 200 to 450°C. Then, alkali metal and a buffer gas are injected and enclosed by bonding glass to an opening portion on an upper surface by the anodic bonding. An alkali metal cell is formed by cutting off each cell from an element formed in this manner.

Such an alkali metal gas cell (hereafter "gas cell") is heated to a predetermined temperature in order to have the enclosed alkali metal and buffer gas in a gaseous state. In order to reduce power consumption in a gas cell, it is necessary to have high thermal resistance in a gas cell portion. Accordingly, a hollow structure is employed for thermal insulation.

Examples of such a hollow structure include a structure (Patent Document 5, FIG. 1, for example) in which a VCSEL light source, a MEMS type gas cell, and a light receiver are stacked three-dimensionally in a traveling direction of light in a quantum unit of a chip-scale atomic clock. When this structure is described in detail, within a package of the quantum unit, a Vertical Cavity Surface Emitting Laser (VCSEL), a quarter-wave plate which is an optical component, an alkali metal gas cell, and a light detector are included. These elements are fixed on a support stage which is made of silicone and fixed on a spacer in order to have a hollow structure. Further, the package and the VCSEL are hardwired using a lead wire for connection to a power supply for operating the quantum unit. Specifically, the lead wire employs a gold wire.

In other examples of a hollow structure, a VCSEL light source is disposed at a center of a light receiver, a gas cell unit is disposed in front thereof, and a mirror and a heating element are disposed on the gas cell unit. A light projected onto the gas cell unit reflects on the mirror and is projected onto a light receiving element (Patent Document 6, FIG. 1, and FIG. 2, for example). In this example, each component is stacked three-dimensionally and a tether is further used to have a hollow structure, so that the structure is complicated.
Patent Document 1: U.S. Patent No. 6806784
Patent Document 2: U.S. Patent Application Publication No. 2005/0007118
Patent Document 3: Japanese Laid-Open Patent Application No. 2009-212416
Patent Document 4: Japanese Laid-Open Patent Application No. 2009-283526
Patent Document 5: Japanese Laid-Open Patent Application No. 2011-237401
Patent Document 6: Japanese Translation Publication No. 2008-520958 of PCT International Application

Non-patent Document 1: Applied Physics Letters, Vol.85, pp.1460-1462 (2004)
Non-patent Document 2: Comprehensive Microsystems, vol.3, pp.571-612

US2006/0022761 discloses a chip-scale atomic clock including an internal cavity, a heater and an emitter/detector disposed on a substrate.

As mentioned above, conventionally proposed hollow structures are complicated and have difficulty in disposing a lead wire. In other words, conventional techniques involve a complicated structure and are not suitable for mass production as each component is stacked and fixed three-dimensionally with high accuracy in a direction of projected light. Further, the conventional techniques have drawbacks in that disposing a lead wire by wire bonding is complicated because components are separated in each layer.

In view of the above-mentioned matter, it is a general object of the present invention to provide an atomic oscillator and the like having a three-dimensional structure and improved mass productivity.

According to an aspect of the invention, an atomic oscillator as defined in the appended claims is provided.

According to an aspect of the invention, it is possible to provide an atomic oscillator and the like having a three-dimensional structure and improved mass productivity.

### Brief Description of Drawings

FIG. 1 is an illustration of an atomic oscillator;
FIG. 2 is a diagram showing an example of a structure of an atomic oscillator according to a first embodiment;
FIG. 3A is a (first) diagram showing an example of a production process of an atomic oscillator according to a first embodiment;
FIG. 3B is a (first) diagram showing an example of a production process of an atomic oscillator according to a first embodiment;
FIG. 3C is a (first) diagram showing an example of a production process of an atomic oscillator according to a first embodiment;
FIG. 4A is a (second) diagram showing an example of a production process of an atomic oscillator according to a first embodiment;
FIG. 4B is a (second) diagram showing an example of a production process of an atomic oscillator according to a first embodiment;
FIG. 5A is a (third) diagram showing an example of a production process of an atomic oscillator according to a first embodiment;
FIG. 5B is a (third) diagram showing an example of a production process of an atomic oscillator according to a first embodiment;
FIG. 6A is a (first) diagram showing an example of a production process of an atomic oscillator according to a second embodiment;
FIG. 6B is a (first) diagram showing an example of a production process of an atomic oscillator according to a second embodiment;
FIG. 6C is a (first) diagram showing an example of a production process of an atomic oscillator according to a second embodiment;
FIG. 7 is a (second) diagram showing an example of a production process of an atomic oscillator according to a second embodiment;
FIG. 8A is a (first) diagram showing an example of a production process of an atomic oscillator according to a third embodiment;
FIG. 8B is a (first) diagram showing an example of a production process of an atomic oscillator according to a third embodiment;
FIG. 9A is a (second) diagram showing an example of a production process of an atomic oscillator according to a third embodiment;
FIG. 9B is a (second) diagram showing an example of a production process of an atomic oscillator according to a third embodiment;
FIG. 10 is a (third) diagram showing an example of a production process of an atomic oscillator according to a third embodiment;
FIG. 11 is a diagram showing an example of a production process of an atomic oscillator according to a fourth embodiment;
FIG. 12A is a diagram showing an example of a production process of an atomic oscillator according to a fifth embodiment;
FIG. 12B is a diagram showing an example of a production process of an atomic oscillator according to a fifth embodiment;
FIG. 13 is a diagram showing an example of a production process of an atomic oscillator according to a sixth embodiment;
FIG. 14A is a (first) diagram showing an example of a production process of an atomic oscillator according to a seventh embodiment;
FIG. 14B is a (first) diagram showing an example of a production process of an atomic oscillator according to a seventh embodiment;
FIG. 15A is a (second) diagram showing an example of a production process of an atomic oscillator according to a seventh embodiment;
FIG. 15B is a (second) diagram showing an example of a production process of an atomic oscillator according to a seventh embodiment;
FIG. 16A is a diagram showing an example of a production process of an atomic oscillator according to an eighth embodiment;
FIG. 16B is a diagram showing an example of a production process of an atomic oscillator according to an eighth embodiment;
FIG. 17A is a (first) diagram showing an example of a production process of an atomic oscillator according to a ninth embodiment;
FIG. 17B is a (first) diagram showing an example of a production process of an atomic oscillator according to a ninth embodiment; and
FIG. 18 is a (second) diagram showing an example of a production process of an atomic oscillator according to a ninth embodiment.

In the following, embodiments for carrying out the present invention are described with reference to the accompanying drawings. In each drawing, the same constituent elements may be given the same reference numerals and redundant descriptions may be omitted.

### <First embodiment>

### [Structure of an atomic oscillator]

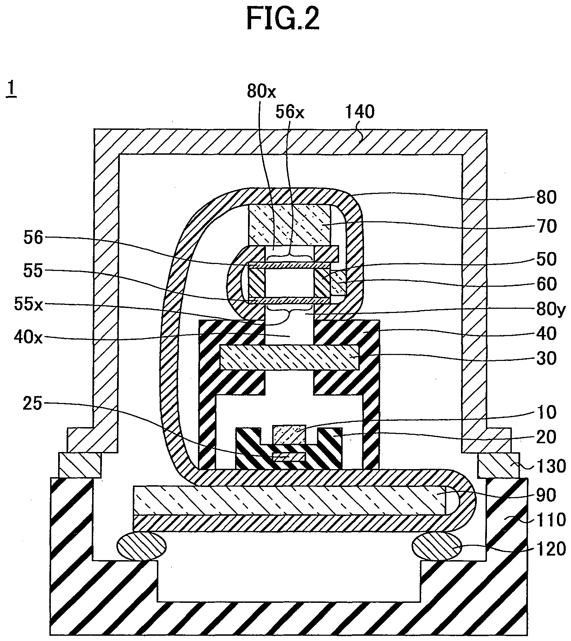

First, a structure of an atomic oscillator is described. FIG. 2 is a diagram showing an example of a structure of an atomic oscillator according to a first embodiment. With reference to FIG. 2, an atomic oscillator 1 according to the first embodiment has a quantum unit including a surface emitting laser device (VCSEL) 10, a first ceramic package 20, an optical component 30, a holder 40, a gas cell 50, a thermistor 60, a photodiode 70, an insulating film 80, and a support 90 as main constituent elements.

In the present embodiment, the photodiode 70 of the atomic oscillator 1 is referred to as an "upper side" and the support 90 is referred to as a "lower side" for convenience sake. However, the atomic oscillator 1 can be used while being positioned upside down or can be disposed at a given angle. Further, planar view indicates viewing an object from a traveling direction of excitation light.

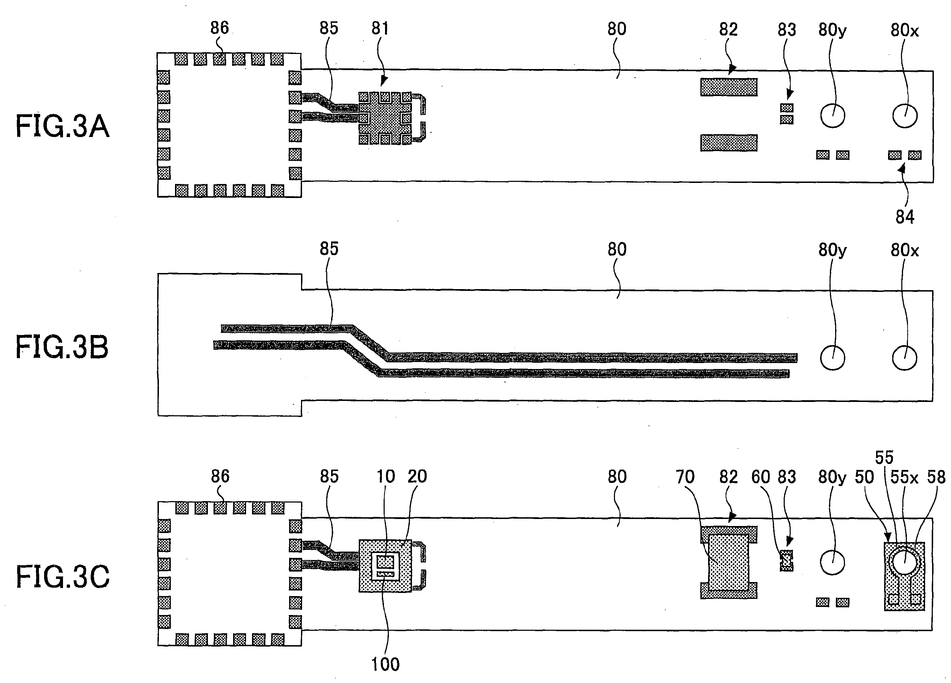

The surface emitting laser device 10 is an excitation light source that emits excitation light to excite alkali metal atoms enclosed in the gas cell 50. A thermistor (thermistor 100 in FIG. 3C) for monitoring a temperature of the surface emitting laser device 10 is mounted on the first ceramic package 20.

The first ceramic package 20 has a built-in heater 25 and the temperature of the surface emitting laser device 10 is controlled based on a temperature detected by the mounted thermistor 100. In other words, the built-in heater 25 and the mounted thermistor 100 of the first ceramic package 20 constitute a temperature control device for the surface emitting laser device 10 which serves as an excitation light source.

Above the first ceramic package 20, the holder 40 for housing the optical component 30 such as a Neutral Density (ND) filter or a quarter-wave plate is disposed. Above the holder 40, the gas cell 50 serving as an alkali metal gas cell is disposed. The thermistor 60 for monitoring a temperature of the gas cell 50 is disposed in the vicinity of the gas cell 50. Materials for the holder 40 may include polycarbonate or the like that transmits excitation light, for example.

In the gas cell 50, a buffer gas and alkali metal are injected into an opening formed in silicone and a lower side of the opening is sealed by a glass plate 55 and an upper side is sealed by a glass plate 56. On each surface of the glass plate 55 and the glass plate 56, a platinum heater (heater 58 in FIG. 3C) is formed. The gas cell 50 is heated by the heater 58 to a predetermined temperature in order to gasify atoms of enclosed alkali metal. The temperature is detected by the thermistor 60 disposed in the vicinity of the gas cell 50 to perform accurate thermal control. In the gas cell 50, a field of the glass plate 55 where an excitation light passes through is referred to as a "window portion 55X" and a field of the glass plate 56 where an excitation light passes through is referred to as a "window portion 56X".

Above the gas cell 50, the photodiode 70 is disposed. The photodiode 70 is a light receiving element that detects an excitation light emitted from the surface emitting laser device 10 and passed through the gas cell 50. The first ceramic package 20, the holder 40, the gas cell 50, the thermistor 60, and the photodiode 70 are fixed on predetermined surfaces of the insulating film 80 and stacked on the support 90 having insulating properties.

The surface emitting laser device 10, the thermistor 100 for monitoring a temperature of the surface emitting laser device 10, the built-in heater 25 in the first ceramic package 20, the heater 58 disposed on the gas cell 50, the thermistor 60, and the photodiode 70 are electrically connected to wiring formed on the insulating film 80. For the insulating film 80, a polyimide film or the like having flexibility and a thickness of about 25 µm may be used. For the support 90, a glass plate or the like may be used.

The thermistor 60 is fixed on a side of the gas cell 50 by a thermally-conductive adhesive (not shown) or the like.

A window portion 40x is defined by a field of the holder 40 where an excitation light passes through. Further, a window portion 80x and a window portion 80y are defined by fields of the insulating film 80 where an excitation light passes through. The window portion 40x, the window portion 80y, the window portion 55x, the window portion 56x, and the window portion 80x are arranged to be in communication with a traveling direction of excitation light (the vertical direction in FIG. 2) and a light receiving surface of the photodiode 70 is exposed to the window portions in communication. In other words, an excitation light from the surface emitting laser device 10 passes through the window portion 40x of the holder 40 housing the optical component 30, the window portion 80y, the window portion 55x, the window portion 56x, and the window portion 80x, and is received by the light receiving surface of the photodiode 70.

In the quantum unit, an emission surface of the surface emitting laser device 10, a surface in the gas cell 50, the surface being perpendicular to a traveling direction of excitation light emitted from the surface emitting laser device 10, and the light receiving surface of the photodiode 70 are located in the same optical path. Further, at least a portion of the insulating film 80 is directly or indirectly sandwiched by the surface emitting laser device 10, the gas cell 50, and the photodiode 70.

In the quantum unit, the support 90 is disposed to face a cavity of a second ceramic package 110 and a connection terminal disposed on the insulating film 80 is connected, via solder 120, to a pad (not shown) disposed within the cavity.

The quantum unit is vacuum sealed for thermal insulation by the second ceramic package 110, a seal ring 130, and a lid 140. For the seal ring 130, kovar or the like subjected to gold plating may be used. For the lid 140, kovar, permalloy, or the like subjected to nickel plating may be used.

### [Method for producing an atomic oscillator]

Next, a method for producing an atomic oscillator is described. FIGs. 3A-5B are diagrams showing an example of a production process of an atomic oscillator according to a first embodiment.

In processes shown in FIG. 3A and FIG. 3B, an insulating film 80 (a polyimide film having a thickness of about 25 µm, for example) is prepared first. FIG. 3A is a plan view showing one side of the insulating film 80 and FIG. 3B is a plan view (bottom view) showing the other side of the insulating film 80 which is a reverse side of the one side. A side on which the first ceramic package 20 is mounted is referred to as "one side" here.

On the insulating film 80, lands 81, 82, 83, and 84 for mounting components, wiring 85, and a connecting terminal 86 are formed. Further, on the insulating film 80, through holes to serve as the window portions 80x and 80y are formed. The lands 81, 82, 83, and 84 for mounting components and the connecting terminal 86 are electrically connected to the wiring 85.

The lands 81, 82, 83, and 84 are formed such that a plurality of components to be mounted on each land is linearly arranged. In other words, the lands 81, 82, 83, and 84 are arranged such that when the quantum unit is assembled while the insulating film 80 is folded or rolled up, each component mounted on each land is linearly arranged in a traveling direction of excitation light.

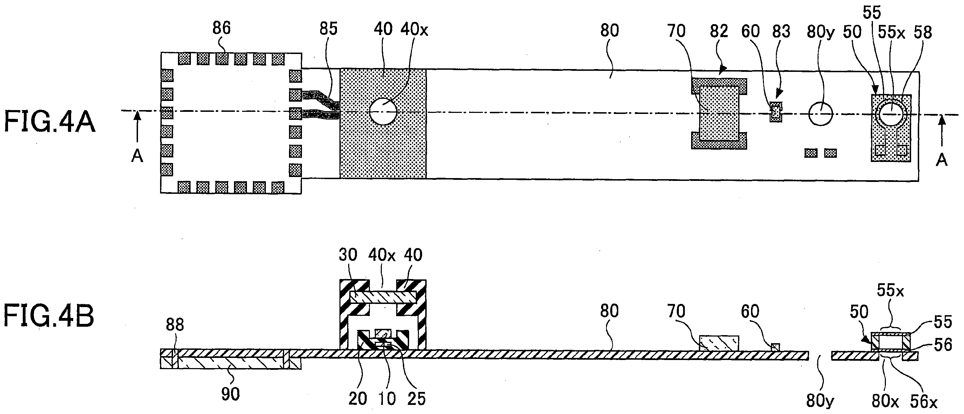

The wiring 85 formed on the one side of the insulating film 80 and the wiring 85 formed on the other side of the insulating film 80 are connected where necessary via a through hole (such as a through hole 88 in FIG. 4B) that penetrates the insulating film 80. In fact, although many patterns of wiring 85 are formed in FIG. 3A and FIG. 3B, only a typical pattern is shown for convenience sake.

Next, in a process shown in FIG. 3C, cream solder or the like is printed on the lands 81, 82, 83, and 84 for mounting components in the insulating film 80. After the printing, the first ceramic package 20 on which the surface emitting laser device 10 and the thermistor 100 are mounted, the photodiode 70, the thermistor 60, and the gas cell 50 are disposed on the lands 81, 82, 83, and 84. However, in the present embodiment, the heater 58 disposed on the gas cell 50 is electrically connected to the land 84 and the gas cell 50 is disposed via the heater 58 (the same applies to the following embodiments). The heater 58 is disposed on a surface of the glass plate 55 such that the heater 58 substantially goes around the window portion 55x in planar view, for example. Further, the heater 58 is disposed on a surface of the glass plate 56 such that the heater 58 substantially goes around the window portion 56x in planar view, for example.

The cream solder or the like is fused by heat treatment with a temperature ranging from about 240 to 260°C and then solidified to electrically connect each land to each component and fix the land and the component. In addition, the gas cell 50 is fixed such that the window portion 55x and the window portion 56x of the gas cell 50 and the window portion 80x of the insulating film 80 are superimposed (in communication) in planar view.

Next, in processes shown in FIG. 4A and FIG. 4B, on the one side of the insulating film 80, the holder 40 made of polycarbonate or the like and housing the optical component 30 is fixed to cover the first ceramic package 20. Further, at a left end on the other side of the insulating film 80, the support 90 (such as a glass plate) is fixed. The fixation of the holder 40 and the support 90 may use heat-resistant resin adhesive or the like. FIG. 4A is a plan view showing the one side of the insulating film 80 and FIG. 4B is a cross-sectional view along the line A-A in FIG. 4A.

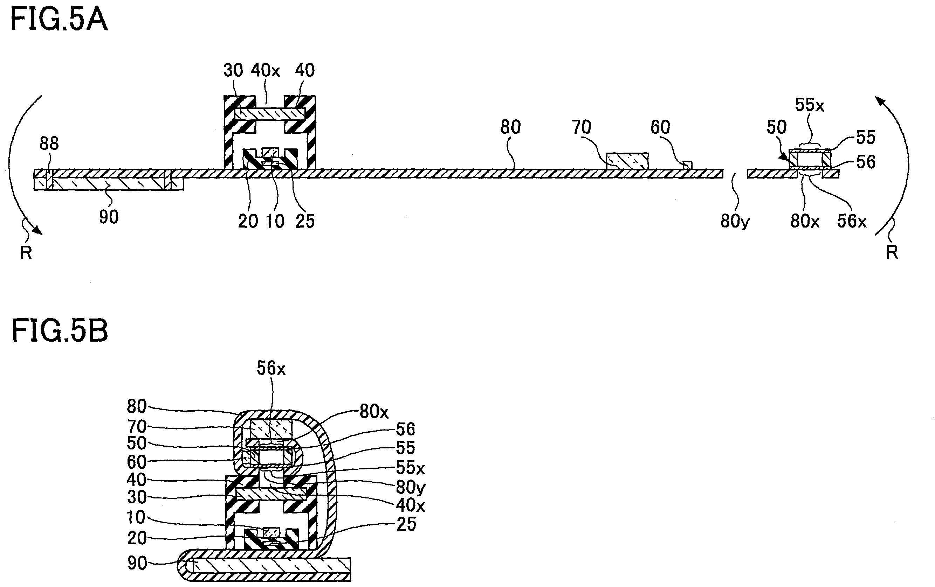

Next, in a process shown in FIG. 5A, the insulating film 80 is rolled up in a direction indicated by an arrow R around the gas cell 50 to stack each component three-dimensionally, and each layer stacked is fixed by heat-resistant ultraviolet-curable resin or the like, thereby assembling a quantum unit as shown in FIG. 5B. The quantum unit is assembled such that the window portion 55x and the window portion 56x of the gas cell 50 and the window portion 80x of the insulating film 80 are superimposed on (in communication with) the window portion 80y of the insulating film 80 in planar view.

Then, the second ceramic package 110, the seal ring 130, and the lid 140 are prepared. The quantum unit shown in FIG. 5B is electrically connected, via the solder 120, to a pad (not shown) disposed within the cavity of the second ceramic package 110. The atomic oscillator 1 shown in FIG. 2 is completed by seam welding the second ceramic package 110 and the lid 140 via the seal ring 130 to have vacuum sealing, for example.

In this manner, in the atomic oscillator having a three-dimensional structure according to the first embodiment, it is possible to dispose each component constituting the quantum unit on the same plane. Accordingly, it is possible to achieve mounting superior in mass productivity using a die bonder or a chip mounter in the same manner as conventionally performed. As a result, it is possible to reduce production costs of the atomic oscillator.

Further, it is possible to check operations of the quantum unit shown in FIG. 5B before mounting it on the second ceramic package 110. Accordingly, it is possible to improve yield of production.

### <Second embodiment>

A second embodiment shows an example where a support different from the support in the first embodiment is used. In the second embodiment, constituent elements that are the same as in the first embodiment mentioned above may be omitted.

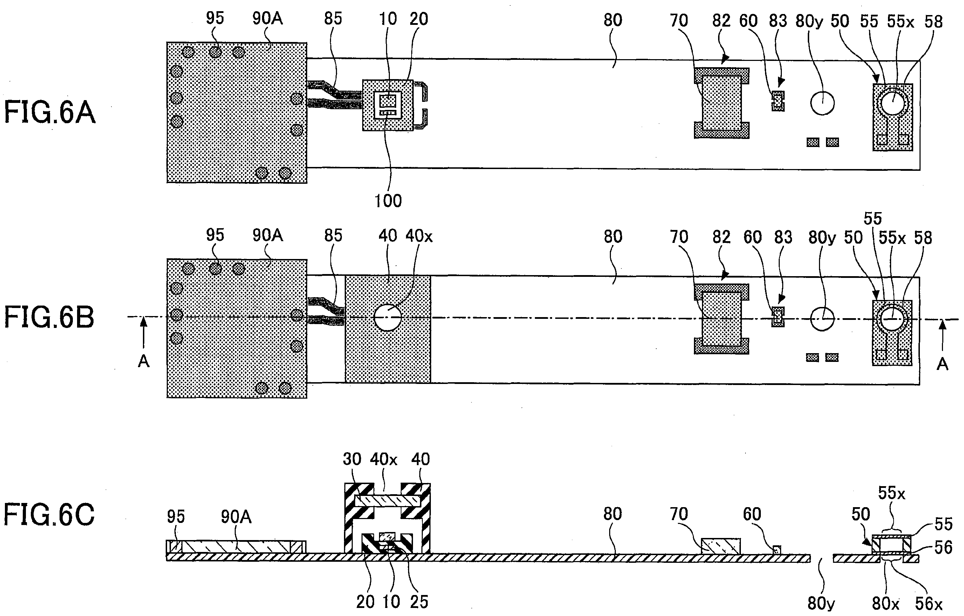

FIGs. 6A to 7 are diagrams showing an example of a production process of an atomic oscillator according to the second embodiment. In a process shown in FIG. 6A, in the same manner as in the processes according to the first embodiment shown in FIG. 3A and FIG. 3B, the insulating film 80 (a polyimide film having a thickness of about 25 µm, for example) is prepared first. Next, cream solder or the like is printed on the lands 81, 82, 83, and 84 for mounting components in the insulating film 80 and a portion necessary on the connecting terminal 86. After the printing, the first ceramic package 20 on which the surface emitting laser device 10 and the thermistor 100 are mounted, the photodiode 70, the thermistor 60, the gas cell 50, and a support 90A are disposed on the lands 81, 82, 83, and 84 and the connecting terminal 86. In addition, a through electrode 95 is formed on a predetermined location of the support 90A (a glass plate, for example).

The cream solder or the like is fused by heat treatment with a temperature ranging from about 240 to 260°C and then solidified to electrically connect each land to each component and fix the land and the component. At the same time, the connecting terminal 86 and the through electrode 95 are electrically connected and fixed. In addition, the gas cell 50 is fixed such that the window portion 55x and the window portion 56x of the gas cell 50 and the window portion 80x of the insulating film 80 are superimposed (in communication) in planar view.

Next, in processes shown in FIG. 6A and FIG. 6B, on one side of the insulating film 80, the holder 40 made of polycarbonate or the like and housing the optical component 30 is fixed to cover the first ceramic package 20. The fixation of the holder 40 may use heat-resistant resin adhesive or the like. FIG. 6B is a plan view showing the one side of the insulating film 80 and FIG. 6C is a cross-sectional view along the line A-A in FIG. 6B.

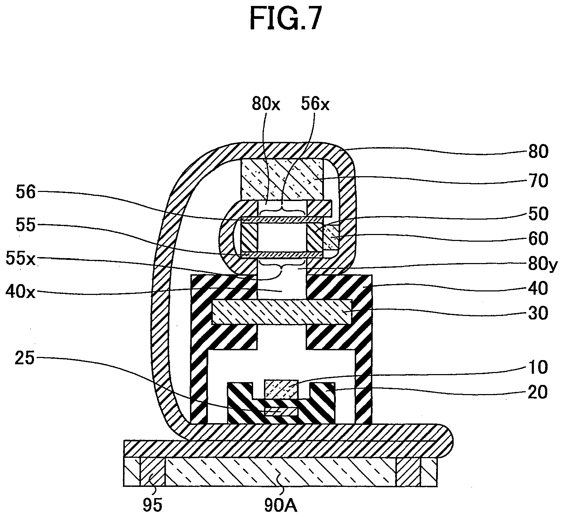

Next, in the same manner as in the process shown in FIG. 5A, the insulating film 80 is rolled up around the gas cell 50 to stack each component three-dimensionally, and each layer stacked is fixed by heat-resistant ultraviolet-curable resin or the like, thereby assembling a quantum unit as shown in FIG. 7. The quantum unit is assembled such that the window portion 55x and the window portion 56x of the gas cell 50 and the window portion 80x of the insulating film 80 are superimposed on (in communication with) the window portion 80y of the insulating film 80 in planar view. Subsequent processes are the same as in the first embodiment.

In this manner, in the second embodiment, the support having the through electrode is used as a support constituting the quantum unit of the atomic oscillator. Accordingly, in addition to effects provided by the first embodiment, following effects are further provided. In other words, the support having the through electrode can be disposed on the same plane (the one side of the insulating film 80) where components including the ceramic package are disposed. Accordingly, it is possible to perform mounting more efficiently using a die bonder or a chip mounter. As a result, it is possible to further reduce production costs of the atomic oscillator.

### <Third embodiment>

A third embodiment shows an example where a location where the ceramic package is mounted is changed to shorten the insulating film. In the third embodiment, constituent elements that are the same as in the previous embodiments mentioned above may be omitted.

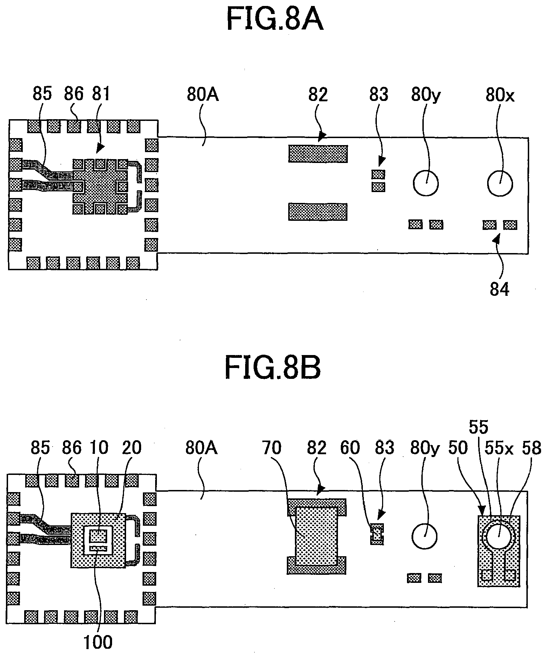

FIGs. 8A-10 are diagrams showing an example of a production process of an atomic oscillator according to the third embodiment. In a process shown in FIG. 8A, an insulating film 80A (a polyimide film having a thickness of about 25 µm, for example) is prepared first. The insulating film 80A is different from the insulating film 80 (see FIG. 3A, for example). In the insulating film 80A, the land 81 for mounting the ceramic package is moved to a field surrounded by the connecting terminal 86. In accordance with this, a total length of the insulating film 80A is reduced. Wiring (not shown) formed on the insulating film 80A is shortened as a matter of course.

Next, in a process shown in FIG. 8B, cream solder or the like is printed on the lands 81, 82, 83, and 84 for mounting components in the insulating film 80A. After the printing, the first ceramic package 20 on which the surface emitting laser device 10 and the thermistor 100 are mounted, the photodiode 70, the thermistor 60, and the gas cell 50 are disposed on the lands 81, 82, 83, and 84. The cream solder or the like is fused by heat treatment with a temperature ranging from about 240 to 260°C and then solidified to electrically connect each land to each component and fix the land and the component. In addition, the gas cell 50 is fixed such that the window portion 55x and the window portion 56x of the gas cell 50 and the window portion 80x of the insulating film 80A are superimposed (in communication) in planar view.

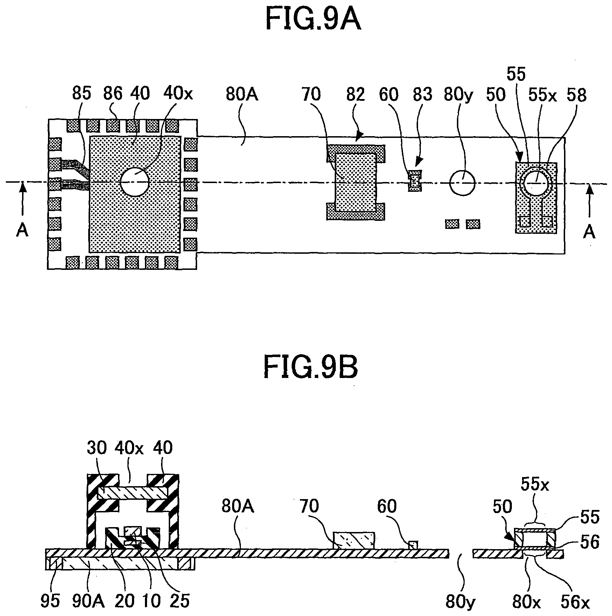

Next, in processes shown in FIG. 9A and 9B, on one side of the insulating film 80A, the holder 40 made of polycarbonate or the like and housing the optical component 30 is fixed to cover the first ceramic package 20. Further, at a left end on the other side of the insulating film 80A, the support 90A is fixed. Since the first ceramic package 20 on which the surface emitting laser device 10 and the thermistor 100 are mounted is disposed immediately above the support 90A, it is possible to shorten wiring between the support 90A and the surface emitting laser device 10 or other components. The fixation of the holder 40 and the support 90A may use heat-resistant resin adhesive or the like. FIG. 9A is a plan view showing the one side of the insulating film 80A and FIG. 9B is a cross-sectional view along the line A-A in FIG. 9A.

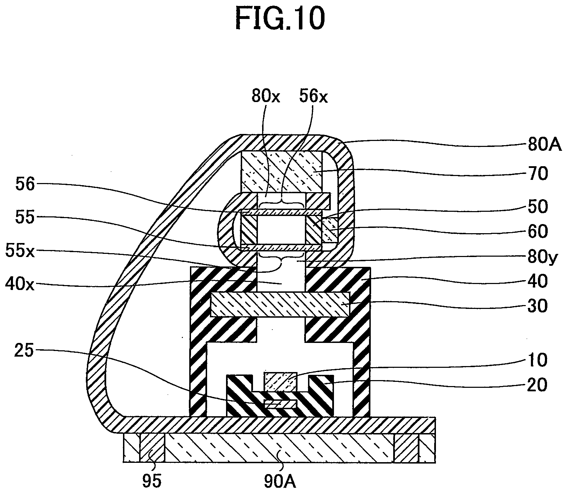

Next, in the same manner as in the process shown in FIG. 5A, the insulating film 80A is rolled up around the gas cell 50 to stack each component three-dimensionally, and each layer stacked is fixed by heat-resistant ultraviolet-curable resin or the like, thereby assembling a quantum unit as shown in FIG. 10. The quantum unit is assembled such that the window portion 55x and the window portion 56x of the gas cell 50 and the window portion 80x of the insulating film 80A are superimposed on (in communication with) the window portion 80y of the insulating film 80A in planar view. Subsequent processes are the same as in the first embodiment.

In this manner, in the third embodiment, the insulating film is shortened by changing a location where the ceramic package is mounted. In accordance with this, in addition to effects provided by the first and second embodiments, following effects are further provided. In other words, by disposing the ceramic package on which the surface emitting laser device is mounted immediately above the support having the through electrode, it is possible to shorten wiring on the insulating film. Accordingly, it is possible to downsize the quantum unit and improve high-frequency characteristics.

### <Fourth embodiment>

A fourth embodiment shows an example where a plurality of quantum units is created at the same time and then individualized. In the fourth embodiment, constituent elements that are the same as in the previous embodiments mentioned above may be omitted.

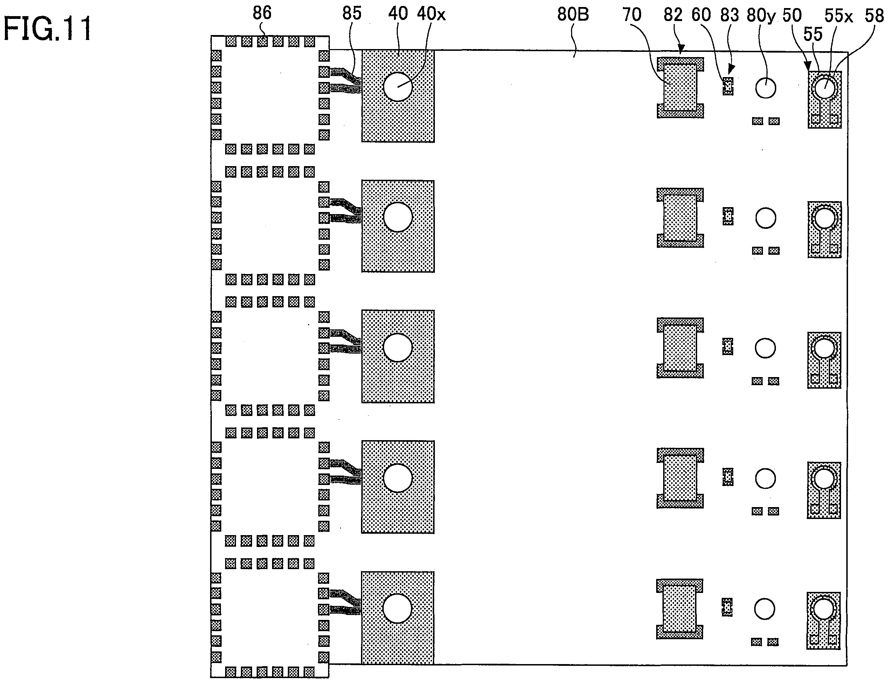

FIG. 11 is a diagram showing an example of a production process of an atomic oscillator according to the fourth embodiment. In a process shown in FIG. 11, an insulating film 80B (a polyimide film having a thickness of about 25 µm, for example) is prepared first. The insulating film 80B is a sheet-like insulating film in which a plurality of lines (five lines in FIG. 11) of lands for mounting components formed to arrange a plurality of components in one direction (one line) in the same manner as in the insulating film 80 shown in FIG. 3A, for example, is arranged in a direction orthogonal to the one direction.

After the first ceramic package 20, the photodiode 70, the thermistor 60, and the gas cell 50 are disposed on each line of the insulating film 80B, they are fixed by heat treatment. Then, the holder 40 is fixed on one side of the insulating film 80B and the support 90 is fixed on the other side.

Next, in the same manner as in the process shown in FIG. 5A, the insulating film 80B is rolled up around the gas cell 50 to stack each component three-dimensionally, and each layer stacked is fixed by heat-resistant ultraviolet-curable resin or the like, thereby assembling a plurality of quantum units connected by the insulating film 80B. Lastly, the plurality of quantum units is divided (individualized) into each unit to create a plurality of (five in this case) separate quantum units which are the same as shown in FIG. 5B. Subsequent processes are the same as in the first embodiment.

In this manner, in the fourth embodiment, after a plurality of quantum units is created at the same time on a single sheet-like insulating film, the plurality of quantum units is divided (individualized) into each unit. Accordingly, mass production of quantum units is further facilitated and it is possible to further reduce production costs.

### <Fifth embodiment>

A fifth embodiment shows an example where a sign used when a quantum unit is assembled is attached to an insulating film. In the fifth embodiment, constituent elements that are the same as in the previous embodiments mentioned above may be omitted.

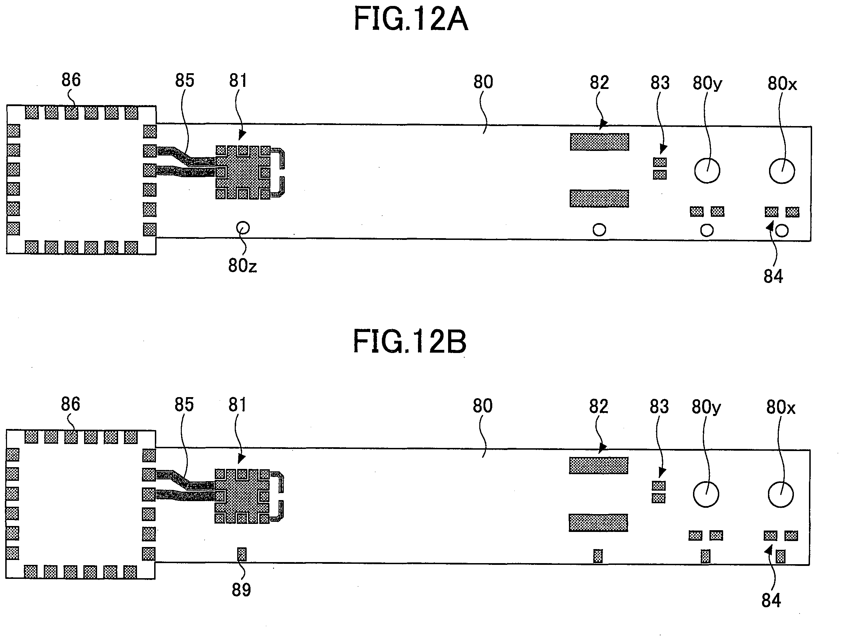

FIGs. 12A and 12B are diagrams showing an example of a production process of an atomic oscillator according to the fifth embodiment. In a process shown in FIGs. 12A to 12B, one of an insulating film shown in FIG. 12A and an insulating film shown in FIG. 12B is prepared. In FIG. 12A, openings 80z for positioning are added to locations in the vicinity of locations where each component is disposed on the insulating film 80 shown in FIG. 3A, for example, the locations being superimposed in a traveling direction of excitation light after a quantum unit is assembled. In FIG. 12B, marks 89 for positioning are added to locations in the vicinity of locations where each component is disposed on the insulating film 80 shown in FIG. 3A, for example, the locations being superimposed in a traveling direction of excitation light after a quantum unit is assembled. The marks 89 may be formed simultaneously with the wiring 85 or the like.

In addition, the opening 80z and the mark 89 may have any kind of shape including a circle, an ellipse, a rectangle, a cross, and the like. Then it is possible to produce an atomic oscillator including a quantum unit in the same procedure as in the first embodiment, in which when the quantum unit is assembled, positioning is performed based on the openings or marks formed on the insulating film.

In this manner, in the fifth embodiment, openings or marks for positioning are formed on the insulating film. When the quantum unit is assembled, it is possible to produce a three-dimensional structure with high accuracy by performing positioning based on the openings or marks formed on the insulating film.

### <Sixth embodiment>

A sixth embodiment shows an example where a substantially T-shaped insulating film is used. In the sixth embodiment, constituent elements that are the same as in the previous embodiments mentioned above may be omitted.

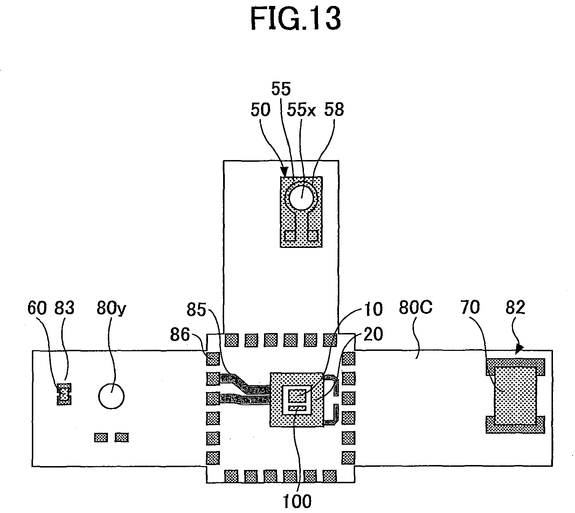

FIG. 13 is a diagram showing an example of a production process of an atomic oscillator according to the sixth embodiment. In a process shown in FIG. 13, an insulating film 80C (a polyimide film having a thickness of about 25 µm, for example) is prepared first.

The insulating film 80C is substantially T-shaped, in which the lands 81, 82, 83, and 84 for mounting components, the wiring 85, and the connecting terminal 86 are formed. Further, on the insulating film 80C, through holes to serve as the window portions 80x and 80y are formed. The lands 81, 82, 83, and 84 and the connecting terminal 86 are electrically connected to the wiring 85.

The lands 81, 82, 83, and 84 are formed such that a plurality of components to be mounded on each land is substantially arranged in a T shape. In other words, the lands 81, 82, 83, and 84 are arranged such that when the quantum unit is assembled while the insulating film 80C is folded or rolled up, each component mounted on each land is linearly arranged in a traveling direction of excitation light.

Next, cream solder or the like is printed on the lands 81, 82, 83, and 84 for mounting components in the insulating film 80C. After the printing, the first ceramic package 20 on which the surface emitting laser device 10 and the thermistor 100 are mounted, the photodiode 70, the thermistor 60, and the gas cell 50 are disposed on the lands 81, 82, 83, and 84. The cream solder or the like is fused by heat treatment with a temperature ranging from about 240 to 260°C and then solidified to electrically connect each land to each component and fix the land and the component.

Following the process shown in FIG. 13, on one side of the insulating film 80C, the holder 40 made of polycarbonate or the like and housing the optical component 30 is fixed to cover the first ceramic package 20. Further, on the other side of the insulating film 80C, the support 90 is fixed. Then the quantum unit is completed by folding the insulating film 80C to a center (to the first ceramic package 20) and fixing the insulating film 80C.

In this manner, in the sixth embodiment, it is possible to shorten wiring to each component by using the substantially T-shaped insulating film instead of a strip-shaped insulating film.

Further, an insulating film in which the lands 81, 82, 83, and 84 are formed such that a plurality of components to be mounted on each land is arranged substantially in a cross shape or radially may be used. In this case, the lands 81, 82, 83, and 84 are arranged such that when the quantum unit is assembled while the insulating film is folded or rolled up, each component mounted on each land is linearly arranged in a traveling direction of excitation light.

### <Seventh embodiment>

A seventh embodiment shows an example where a reinforcement member is disposed on an insulating film. In the seventh embodiment, constituent elements that are the same as in the previous embodiments mentioned above may be omitted.

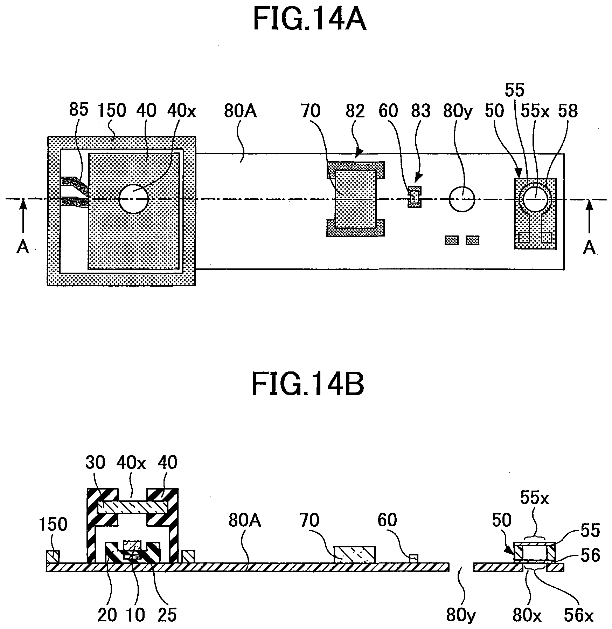

FIGs. 14A to 15B are diagrams showing an example of a production process of an atomic oscillator according to the seventh embodiment. In processes shown in FIG. 14A and FIG. 14B, the insulating film 80A (a polyimide film having a thickness of about 25 µm, for example) is prepared first. FIG. 14A is a plan view showing one side of the insulating film 80A and FIG. 14B is a cross-sectional view along the line A-A in FIG. 14A.

Next, cream solder or the like is printed on the lands 81, 82, 83, and 84 for mounting components in the insulating film 80A. After the printing, the first ceramic package 20 on which the surface emitting laser device 10 and the thermistor 100 are mounted, the photodiode 70, the thermistor 60, and the gas cell 50 are disposed on the lands 81, 82, 83, and 84. The cream solder or the like is fused by heat treatment with a temperature ranging from about 240 to 260°C and then solidified to electrically connect each land to each component and fix the land and the component.

Next, on one side of the insulating film 80A, the holder 40 made of polycarbonate or the like and housing the optical component 30 is fixed to cover the first ceramic package 20. Further, on the one side of the insulating film 80A, a frame-shaped reinforcement member 150, for example, is fixed to surround the holder 40. Examples of materials for the reinforcement member 150 may include heat-resistant resin, metal (such as aluminum), or the like. In this embodiment, a support is not used.

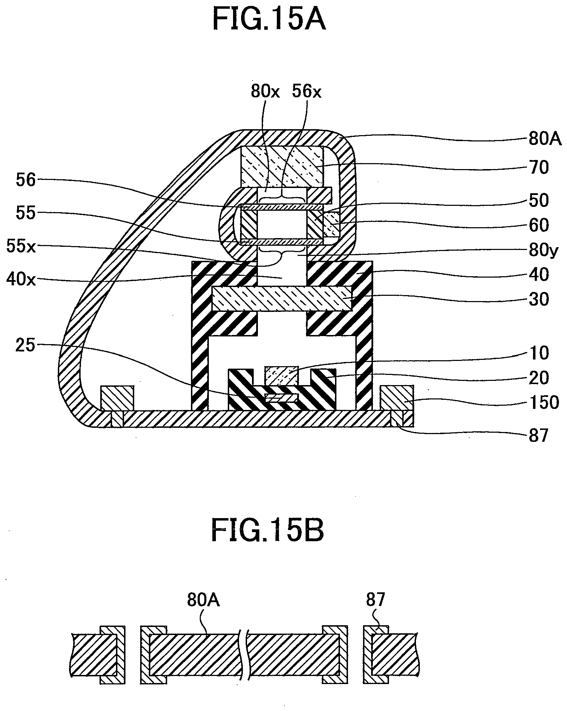

Next, in a process shown in FIG. 15A, in the same manner as in the process shown in FIG. 5A, the insulating film 80A is rolled up around the gas cell 50 to stack each component three-dimensionally, and each layer stacked is fixed by heat-resistant ultraviolet-curable resin or the like, thereby assembling a quantum unit. Subsequent processes are the same as in the first embodiment.

In addition, as shown in FIG. 15B which is a partially enlarged view of FIG. 15A, on a predetermined location of the insulating film 80A, a conductor 87 penetrating from one side to the other side of the insulating film 80A is disposed. The predetermined location of the insulating film 80A may be a bottom of the reinforcement member 150, for example. Since the conductor 87 functions in the same manner as the through electrode 95 (see FIG. 9B, for example) of the support 90, the present embodiment may not employ a support having a through electrode.

In this manner, in the seventh embodiment, it is possible to remove a support having a through electrode by using an insulating film on which a conductor penetrating from a surface to a back surface thereof is disposed. In this case, it is possible to secure strength by fixing the reinforcement member so as to surround the holder.

### <Eighth embodiment>

An eighth embodiment shows an example where the photodiode is fixed on the other side of an insulating film. In the eighth embodiment, constituent elements that are the same as in the previous embodiments mentioned above may be omitted.

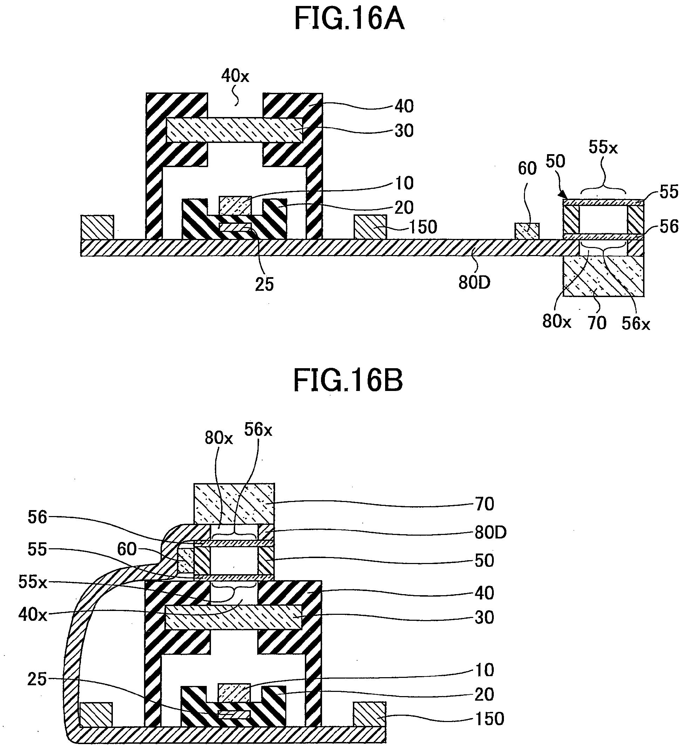

FIG. 16A and FIG. 16B are diagrams showing an example of a production process of an atomic oscillator according to the eighth embodiment. In a process shown in FIG. 16A, an insulating film 80D (a polyimide film having a thickness of about 25 µm, for example) is prepared first.

Next, cream solder or the like is printed on the lands 81, 83, and 84 for mounting components in the insulating film 80D. The insulating film 80D is turned over and cream solder or the like is printed on the land 82. After the printing, the first ceramic package 20 on which the surface emitting laser device 10 and the thermistor 100 are mounted, the thermistor 60, and the gas cell 50 are disposed on the lands 81, 83, and 84. Then the insulating film 80D is turned over and the photodiode 70 is disposed on the land 82. The cream solder or the like is fused by heat treatment with a temperature ranging from about 240 to 260°C and then solidified to electrically connect each land to each component and fix the land and the component.

The land 82 on which the photodiode 70 is mounted is disposed on the other side of the insulating film 80D. Accordingly, the components are fixed such that the window portion 55x and the window portion 56x of the gas cell 50 and the window portion 80x of the insulating film 80D are superimposed (in communication) in planar view and the light receiving surface of the photodiode 70 is exposed within the superimposed window portions. In the present embodiment, the photodiode 70 must employ a photodiode that has a cathode and an anode on the light receiving surface.

Next, on one side of the insulating film 80D, the holder 40 made of polycarbonate or the like and housing the optical component 30 is fixed to cover the first ceramic package 20. Further, on the one side of the insulating film 80D, a frame-shaped reinforcement member 150, for example, is fixed to surround the holder 40. Examples of materials for the reinforcement member 150 may include heat-resistant resin, metal (such as aluminum), or the like. In this embodiment, a support is not used.

Next, in a process shown in FIG. 16B, the insulating film 80D is folded such that the holder 40 and the gas cell 50 are positioned inside to stack each component three-dimensionally, and each layer stacked is fixed by heat-resistant ultraviolet-curable resin or the like, thereby assembling a quantum unit. Subsequent processes are the same as in the first embodiment. Further, in the same manner as in FIG. 15B, on a predetermined location of the insulating film 80D, the conductor 87 penetrating from a surface to a back surface of the insulating film 80D is disposed. Since the conductor 87 functions in the same manner as the through electrode 95 (see FIG. 9B, for example) of the support 90, the present embodiment may not employ a support having a through electrode.

In this manner, in the eighth embodiment, it is possible to remove a support having a through electrode by using an insulating film on which a conductor penetrating from a surface to a back surface thereof is disposed. Further, it is possible to secure strength by fixing the reinforcement member so as to surround the holder. Further, since the gas cell and the photodiode are disposed on the surface and the back surface of the insulating film such that they are superimposed in planar view, it is possible to shorten wiring on the insulating film. Accordingly, it is possible to downsize the quantum unit and improve high-frequency characteristics.

### <Ninth embodiment>

A ninth embodiment shows an example where the built-in heater included in the ceramic package and the heater disposed on the gas cell are formed on a surface of an insulating film and the surface emitting laser device is directly mounted on one side of the insulating film without using the ceramic package. In other words, in the present embodiment, the ceramic package is not used or the heater is not disposed on the gas cell. In the ninth embodiment, constituent elements that are the same as in the previous embodiments mentioned above may be omitted.

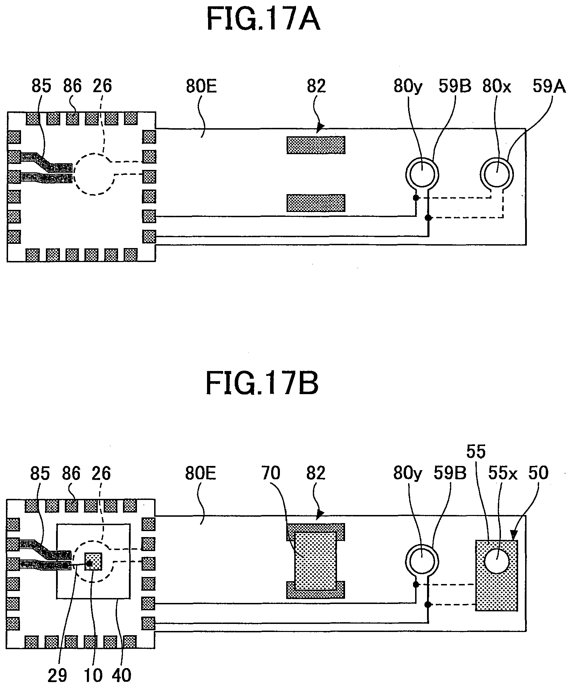

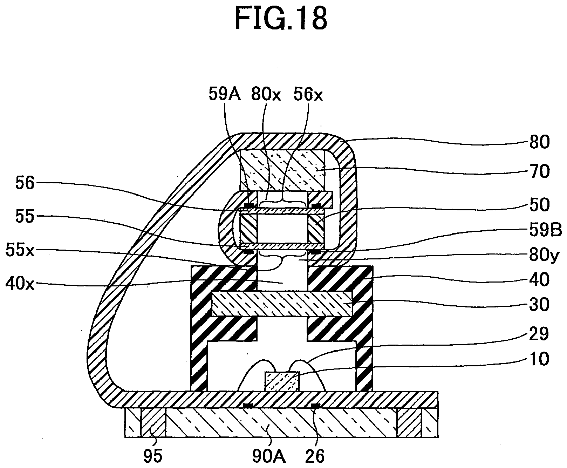

FIGs. 17A to 18 are diagrams showing an example of a production process of an atomic oscillator according to the ninth embodiment. FIG. 17A and FIG. 17B are plan views showing one side of an insulating film 80E. FIG. 18 is a cross-sectional view showing components that are three-dimensionally stacked. In FIGs. 17A and 17B, broken lines indicate presence on the other side of the insulating film 80E.

In a process shown in FIG. 17A, the insulating film 80E (a polyimide film having a thickness of about 25 µm, for example) is prepared first. The insulating film 80E houses a heater 26 for heating the surface emitting laser device 10 and a heater 59A and a heater 59B for heating the gas cell 50.

Specifically, on one side of the insulating film 80E, the heater 59A is formed such that the heater 59A substantially goes around a through hole which is to serve as the window portion 80x and the heater 59B is formed such that the heater 59B substantially goes around a through hole which is to serve as the window portion 80y. One end of the heater 59A and one end of the heater 59B are connected. A portion connected to both of one ends is further connected to the connecting terminal 86. Another end of the heater 59A and another end of the heater 59B are connected. A portion connected to both of another ends is further connected to the connecting terminal 86.

On the other side of the insulating film 80E, the heater 26 is formed such that the heater 26 substantially goes around a reverse side of a field on which the surface emitting laser device 10 is to be mounted. One end and another end of the heater 26 are connected to the connecting terminal 86.

The heaters 59A and 59B and the heater 26 may be made of a metallic material having relatively high resistivity. For example, one of or both of the heaters 59A and 59B and the heater 26 may be made of platinum. The heaters 59A and 59B and the heater 26 may be formed by sputtering, for example. A protective layer made of an insulating material may be disposed to cover the heaters 59A and 59B and the heater 26.

On the insulating film 80E, unlike the insulating film 80A (see FIG. 9A, for example), the lands 81, 83, and 84 for mounting components are not formed. This is because in the present embodiment, the insulating film 80E houses the heater 26, so that the first ceramic package 20 including the built-in heater 25 is not mounted. This is also because in the present embodiment, the insulating film 80E houses the heaters 59A and 59B, so that the heater 58 is not disposed on the gas cell 50. Further, this is because it is possible to detect temperature using a temperature coefficient of resistance of platinum by forming the heaters 59A and 59B from platinum, so that there is no need to mount the thermistor 60. In the present embodiment, the heater 26 constitutes a temperature control device for the surface emitting laser device 10 which serves as an excitation light source and the heaters 59A and 59B constitute a temperature control device for the gas cell 50 which serves as a gas cell.

Next, in a process shown in FIG. 17B, cream solder or the like is printed on the land 82 for mounting a component in the insulating film 80E. After the printing, the photodiode 70 is disposed on the land 82. The cream solder or the like is fused by heat treatment with a temperature ranging from about 240 to 260°C and then solidified to electrically connect the land 82 to the photodiode 70 and fix the land 82 and the photodiode 70.

Further, the surface emitting laser device 10 and the gas cell 50 are fixed on the one side of the insulating film 80E (not electrically connected). The fixation of the surface emitting laser device 10 and the gas cell 50 may use heat-resistant resin adhesive or the like. Unlike other embodiments, the surface emitting laser device 10 is directly fixed on the one side of the insulating film 80E without using the first ceramic package 20. The gas cell 50 is fixed such that the window portion 55x and the window portion 56x of the gas cell 50 and the window portion 80x of the insulating film 80E are superimposed (in communication) in planar view.

Then a terminal of the surface emitting laser device 10 and an end of the wiring 85 are electrically connected by bonding using a metal wire 29 such as a gold wire or the like. Subsequently, on the one side of the insulating film 80E, the holder 40 made of polycarbonate or the like and housing the optical component 30 is fixed to cover the surface emitting laser device 10. Further, at a left end on the other side of the insulating film 80E, the support 90A is fixed. Since the surface emitting laser device 10 is disposed immediately above the support 90A, it is possible to shorten wiring between the support 90A and the surface emitting laser device 10 or other components. The fixation of the holder 40 and the support 90A may use heat-resistant resin adhesive or the like.

Next, in the same manner as in the process shown in FIG. 5A, the insulating film 80E is rolled up around the gas cell 50 to stack each component three-dimensionally, and each layer stacked is fixed by heat-resistant ultraviolet-curable resin or the like, thereby assembling a quantum unit shown in FIG. 18. The quantum unit is assembled such that the window portion 55x and the window portion 56x of the gas cell 50 and the window portion 80x of the insulating film 80E are superimposed on (in communication with) the window portion 80y of the insulating film 80E in planar view. Subsequent processes are the same as in the first embodiment.

In this manner, in the ninth embodiment, the built-in heater included in the first ceramic package 20 and the heater disposed on the gas cell 50 in other embodiments are formed on a surface of the insulating film 80E. Further, the surface emitting laser device 10 is directly mounted on the one side of the insulating film 80E without using the first ceramic package 20. As a result, it is possible to further downside the quantum unit in comparison with other embodiments.

If a heater is disposed on the gas cell 50 as in other embodiments, the heater disposed on the gas cell 50 needs to be electrically connected to a land of the insulating film. However, in the present embodiment, the heater is formed on the insulating film 80E, so that the insulating film 80E has only to be bonded to the gas cell 50 without being electrically connected thereto. This provides an advantage in simplifying a process.

Further, it is possible to detect temperature using a temperature coefficient of resistance of platinum by forming one of or both of the heaters 59A and 59B and the heater 26 from platinum, so that the thermistor 60 and the thermistor 100 may be removed. Accordingly, it is possible to achieve further downsizing.

The present invention is not limited to the specifically disclosed embodiments, but various variations and modifications may be made without departing from the scope of the present invention as defined by the appended claims.

### Description of the Reference Numerals

- 1: atomic oscillator
- 10: surface emitting laser device
- 20: first ceramic package
- 25: built-in heater
- 30: optical component
- 40: holder
- 40x, 55x, 56x, 80x, 80y: window portion
- 50: gas cell
- 55, 56: glass plate
- 58: heater
- 80z: opening
- 60, 100: thermistor
- 70: photodiode
- 80, 80A, 80B, 80C, 80D: insulating film
- 81, 82, 83, 84: land
- 85: wiring
- 86: connecting terminal
- 87: conductor
- 89: mark
- 90, 90A: support
- 95: through electrode
- 110: second ceramic package
- 120: solder
- 130: seal ring
- 140: lid
- 150: reinforcement member

## Claims

1. An atomic oscillator comprising:
a gas cell (50); and
a plurality of electric components, wherein the plurality of electric components include:
a temperature control device (58) for the gas cell;
an light source (10) configured to emit light to be projected onto the gas cell;
a temperature control device (25,100) for the excitation light source; and
a light receiving element (70) configured to detect the excitation light that passes through the gas cell (50),
wherein at least a plurality of the electric components are mounted on an insulating film (80) having wiring (85); **characterized in that**
the insulating film (80) is folded or rolled up; and, in an assembled state of the atomic oscillator, the electric components mounted on the insulating film (80) are arranged linearly in the traveling direction of the excitation light.

2. The atomic oscillator as claimed in claim 1, wherein at least a portion of the insulating film (80) is directly or indirectly sandwiched by the light source (10), the gas cell (50) and the light receiving element (70).

3. The atomic oscillator as claimed in claim 1 or 2, wherein a field of the insulating film where the light passes through comprises a window portion (80x, 80y) to transmit the excitation light.

4. The atomic oscillator as claimed in any one of claims 1 to 3, wherein the insulating film (80) comprises a conductor (95) penetrating from one side to the other side of the insulating film (80).

5. The atomic oscillator as claimed in any one of claims 1 to 4, wherein the insulating film comprises an opening or a mark (89) at locations superimposed in a traveling direction of the light.

6. The atomic oscillator as claimed in any one of claims 1 to 5, wherein the electric components mounted on the insulating film include:
the temperature control device (58) for the gas cell (50); and
the temperature control (25,100) for the light source (10).

7. The atomic oscillator as claimed in any one of claims 1-6, wherein the insulating film houses the temperature control device (25,100) for the excitation light source (10) and the temperature control device (58) for the gas cell (50).

8. The atomic oscillator as claimed in claim 7, wherein at least one of the temperature control device (25,100) for the excitation light source (10) and the temperature control device (58) for the gas cell (50) is made of platinum.

9. The atomic oscillator as claimed in any one of claims 1 to 8, further comprising a plurality of lands (81, 82, 83, 84) for mounting the electric components on the insulating film (80), the plurality of lands being connected to the wiring (58).

10. The atomic oscillator as claimed in claim 9, wherein the plurality of lands (81,82,83,84) are formed such that the plurality of components are arranged radially, in a T shape, or in a cross shape.

11. A method for producing an atomic oscillator, the atomic oscillator (1) having a quantum unit including a gas cell and electric components including a light source that emits light to be projected onto the gas cell and a light receiving element that detects the light that passes through the gas cell, the method comprising:
mounting a plurality of the electric components that constitute a quantum unit of the atomic oscillator on an insulating film (80) having wiring (85);
folding or rolling up the insulating film to assemble the quantum unit; and
electrically connecting the quantum unit to a package to seal the quantum unit.

12. A method for producing an atomic oscillator, the atomic oscillator having a quantum unit including a gas cell and electric components including a light source that emits light to be projected onto the gas cell and a light receiving element that detects the light that passes through the gas cell, the method comprising:
mounting a plurality of the electric components that constitute a quantum unit of the atomic oscillator (1) on an insulating film (80) where a plurality of lines of lands (81, 82, 83, 84) for mounting the plurality of components, the lands being formed to arrange the plurality of the electric components in one direction, are arranged in a direction orthogonal to the one direction;
folding or rolling up the insulating film to assemble a plurality of quantum units connected by the insulating film; and
dividing the plurality of quantum units individually; and
electrically connecting each of the quantum units to a package to seal each of the quantum units.

13. The method for producing an atomic oscillator as claimed in claim 11 or 12, wherein the folding or rolling up the insulating film comprises positioning based on an opening or a mark (89) formed on the insulating film.

## Patentansprüche

1. Atomoszillator, umfassend:
eine Gaszelle (50); und
eine Vielzahl elektrischer Komponenten, wobei die Vielzahl elektrischer Komponenten beinhaltet:
eine Temperaturregelvorrichtung (58) für die Gaszelle;
eine Lichtquelle (10), die konfiguriert ist, um Licht zu emittieren, das auf die Glaszelle projiziert werden soll;
eine Temperaturregelvorrichtung (25, 100) für die Erregungslichtquelle; und
ein Lichtempfangselement (70), das konfiguriert ist, um das Erregungslicht, das durch die Gaszelle (50) hindurchtritt, zu erfassen,
wobei mindestens eine Vielzahl der elektrischen Komponenten auf einem Isolierfilm (80) befestigt ist, die eine Verdrahtung (85) hat; **dadurch gekennzeichnet, dass**
der Isolierfilm (80) gefaltet oder aufgerollt ist; und, in einem montierten Zustand des Atomoszillators, die elektrischen Komponenten, die auf dem Isolierfilm (80) befestigt sind, linear in die Bewegungsrichtung des Erregungslichts angeordnet sind.

2. Atomoszillator nach Anspruch 1, wobei mindestens ein Teil des Isolierfilms (80) direkt oder indirekt von der Lichtquelle (10), der Gaszelle (50) und dem Lichtempfangselement (70) eingeschlossen ist.

3. Atomoszillator nach Anspruch 1 oder 2, wobei ein Feld des Isolierfilms dort, wo das Licht hindurchtritt, ein Fensterteil (80x, 80y) umfasst, um das Erregungslicht zu übertragen.

4. Atomoszillator nach einem der Ansprüche 1 bis 3, wobei der Isolierfilm (80) einen Leiter (95) umfasst, der den Isolierfilm (80) von einer Seite auf die andere Seite durchdringt.

5. Atomoszillator nach einem der Ansprüche 1 bis 4, wobei die Isolierfilm eine Öffnung oder eine Markierung (89) an Stellen umfasst, die in eine Bewegungsrichtung des Lichts überlagert sind.

6. Atomoszillator nach einem der Ansprüche 1 bis 5, wobei die elektrischen Komponenten, die auf dem Isolierfilm montiert sind, Folgendes beinhalten:
die Temperaturregelvorrichtung (58) für die Gaszelle (50); und
die Temperaturregelung (25, 100) für die Lichtquelle (10).

7. Atomoszillator nach einem der Ansprüche 1-6, wobei der Isolierfilm die Temperaturregelvorrichtung (25, 100) für die Erregungslichtquelle (10) und die Temperaturregelvorrichtung (58) für die Gaszelle (50) aufnimmt.

8. Atomoszillator nach Anspruch 7, wobei mindestens eines von der Temperaturregelvorrichtung (25, 100) für die Erregungslichtquelle (10) und der Temperaturregelvorrichtung (58) für die Gaszelle (50) aus Platin sind.

9. Atomoszillator nach einem der Ansprüche 1 bis 8, der ferner eine Vielzahl von Stegen (81, 82, 83, 84) zum Montieren der elektrischen Komponenten auf dem Isolierfilm (80) umfasst, wobei die Vielzahl von Stegen mit der Verdrahtung (58) verbunden sind.

10. Atomoszillator nach Anspruch 9, wobei die Vielzahl von Stegen (81, 82, 83, 84) so gebildet sind, dass die Vielzahl Komponenten radial, T-förmig, oder kreuzförmig angeordnet sind.

11. Verfahren zur Herstellung eines Atomoszillators, wobei der Atomoszillator (1) eine Quantum-Einheit hat, die eine Gaszelle und elektrische Komponenten beinhaltet, die eine Lichtquelle beinhaltet, die Licht emittiert, das auf die Glaszelle projiziert werden soll, und ein Lichtempfangselement, das das Licht erfasst, das durch die Gaszelle hindurchtritt, wobei das Verfahren Folgendes umfasst:
Befestigen einer Vielzahl elektrischer Komponenten, die eine Quantum-Einheit des Atomoszillators bilden, auf einem Isolierfilm (80), die eine Verdrahtung (85) hat;
Falten oder Aufrollen des Isolierfilms, um die Quantum-Einheit zusammenzusetzen; und
elektrisches Verbinden der Quantum-Einheit mit einer Verpackung, um die Quantum-Einheit zu versiegeln.

12. Verfahren zur Herstellung eines Atomoszillators, wobei der Atomoszillator eine Quantum-Einheit hat, die eine Gaszelle und elektrische Komponenten beinhaltet, die eine Lichtquelle beinhaltet, die Licht emittiert, das auf die Glaszelle projiziert werden soll, und ein Lichtempfangselement, das das Licht erfasst, das durch die Gaszelle hindurchtritt, wobei das Verfahren Folgendes umfasst:
Montieren einer Vielzahl elektrischer Komponenten, die eine Quantum-Einheit des Atomoszillators (1) bilden, auf einem Isolierfilm (80), wobei die Vielzahl der Stegleitungen (81, 82, 83, 84) zum Montieren der Vielzahl Komponenten, wobei die Stege gebildet sind, um die Vielzahl elektrischer Komponenten in eine Richtung anzuordnen, in einer Richtung orthogonal zu der einen Richtung angeordnet werden;
Falten oder Aufrollen des Isolierfilms, um eine Vielzahl Quantum-Einheiten zusammenzusetzen, die durch den Isolierfilm verbunden sind; und
individuelles Trennen der Vielzahl Quantum-Einheiten; und
elektrisches Verbinden jeder der Quantum-Einheiten mit einer Verpackung, um jede der Quantum-Einheiten zu versiegeln.

13. Verfahren zur Herstellung eines Atomoszillators nach Anspruch 11 oder 12, wobei das Falten oder Aufrollen des Isolierfilms eine Positionierung basierend auf einer Öffnung oder einer Markierung (89), die auf der Isolierschicht gebildet ist, umfasst.

## Revendications

1. Oscillateur atomique comprenant :
une cellule gazeuse (50) ; et
une pluralité de composants électriques, la pluralité de composants électriques comprenant :
un dispositif de commande de température (58) pour la cellule gazeuse ;
une source lumineuse (10) conçue pour émettre la lumière devant être projetée sur la cellule gazeuse ;
un dispositif de commande de température (25, 100) pour la source lumineuse d'excitation ; et
un élément récepteur de lumière (70) conçu pour détecter la lumière d'excitation qui passe par la cellule gazeuse (50),
au moins une pluralité des composants électriques étant montés sur un film isolant (80) ayant un câblage (85) ; **caractérisé en ce que**
le film isolant (80) est plié ou enroulé ; et, dans un état assemblé de l'oscillateur atomique, les composants électriques montés sur le film isolant (80) sont agencés linéairement dans la direction de déplacement de la lumière d'excitation.

2. Oscillateur atomique tel que défini dans la revendication 1, dans lequel au moins une partie du film isolant (80) est intercalée directement ou indirectement entre la source lumineuse (10), la cellule gazeuse (50) et l'élément récepteur de lumière (70).

3. Oscillateur atomique tel que défini dans la revendication 1 ou 2, dans lequel un champ du film isolant où la lumière passe à travers comprend une partie de fenêtre (80x, 80y) pour transmettre la lumière d'excitation.

4. Oscillateur atomique tel que défini dans l'une quelconque des revendications 1 à 3, dans lequel le film isolant (80) comprend un conducteur (95) pénétrant d'un côté à l'autre côté du film isolant (80).

5. Oscillateur atomique tel que défini dans l'une quelconque des revendications 1 à 4, dans lequel le film isolant comprend une ouverture ou une marque (89) à des emplacements superposés dans une direction de déplacement de la lumière.

6. Oscillateur atomique tel que défini dans l'une quelconque des revendications 1 à 5, dans lequel les composants électriques montés sur le film isolant comprennent :
le dispositif de commande de température (58) pour la cellule gazeuse (50) ; et
le dispositif de commande de température (25, 100) pour la source lumineuse (10).

7. Oscillateur atomique tel que défini dans l'une quelconque des revendications 1 à 6, dans lequel le film isolant abrite le dispositif de commande de température (25, 100) pour la source lumineuse d'excitation (10) et le dispositif de commande de température (58) pour la cellule gazeuse (50).

8. Oscillateur atomique tel que défini dans la revendication 7, dans lequel le dispositif de commande de température (25, 100) pour la source lumineuse d'excitation (10) et/ou le dispositif de commande de température (58) pour la cellule gazeuse (50) est/sont constitué(s) de platine.

9. Oscillateur atomique tel que défini dans l'une quelconque des revendications 1 à 8, comprenant en outre une pluralité de surfaces de contact (81, 82, 83, 84) destinées à monter les composants électriques sur le film isolant (80), la pluralité de surfaces de contact étant reliée au câblage (58).

10. Oscillateur atomique tel que défini dans la revendication 9, dans lequel la pluralité de surfaces de contact (81, 82, 83, 84) est formée de manière que la pluralité de composants est agencée radialement, en forme de T ou en forme de croix.

11. Procédé de fabrication d'un oscillateur atomique, l'oscillateur atomique (1) ayant une unité quantique comprenant une cellule gazeuse et des composants électriques comprenant une source lumineuse qui émet la lumière devant être projetée sur la cellule gazeuse et un élément récepteur de lumière qui détecte la lumière qui passe par la cellule gazeuse, le procédé comprenant :
le montage d'une pluralité de composants électriques qui constituent une unité quantique de l'oscillateur atomique sur un film isolant (80) ayant un câblage (85) ;
le pliage ou l'enroulement du film isolant pour assembler l'unité quantique ; et
la connexion électrique de l'unité quantique à un paquet pour sceller l'unité quantique.

12. Procédé de fabrication d'un oscillateur atomique, l'oscillateur atomique ayant une unité quantique comprenant une cellule gazeuse et des composants électriques comprenant une source lumineuse qui émet de la lumière devant être projetée sur la cellule gazeuse et un élément récepteur de lumière qui détecte la lumière qui passe par la cellule gazeuse, le procédé comprenant :
l'assemblage d'une pluralité de composants électriques qui constituent une unité quantique de l'oscillateur atomique (1) sur un film isolant (80) où une pluralité de lignes de surfaces de contact (81, 82, 83, 84) destinées à monter la pluralité de composants, les surfaces de contact étant formées pour agencer la pluralité des composants électriques dans une direction, est agencée dans une direction perpendiculaire à la direction ;
le pliage ou le roulement du film isolant pour assembler une pluralité d'unités quantiques reliées par le film isolant ; et
la division individuelle de la pluralité d'unités quantiques ; et
la connexion électrique de chaque unité quantique à un paquet pour sceller chacune des unités quantiques.

13. Procédé de fabrication d'un oscillateur atomique tel que défini dans la revendication 11 ou 12, dans lequel le pliage ou roulement du film isolant comprend le positionnement en fonction d'une ouverture ou d'une marque (89) formée sur le film isolant.
